# FASCICULE DE BREVET EUROPEEN

(11) **EP 3 177 123 B1**
(45) Date de publication et mention de la délivrance du brevet: **24.02.2021**
(21) Numéro de dépôt: 16201053.2
(22) Date de dépôt: 29.11.2016
(51) Int. Cl.: H05K 7/14, H05K 3/30, H02K 11/04

(54) **SUPPORT D'UNE CARTE ELECTRONIQUE, ENSEMBLE D'UNE CARTE ELECTRONIQUE ET D'UN TEL SUPPORT, CONVERTISSEUR DE TENSION LE COMPRENANT ET MACHINE ELECTRIQUE POUR VEHICULE AUTOMOBILE LE COMPRENANT**
HALTERUNG FÜR ELEKTRONISCHE KARTE, EINHEIT EINER SOLCHEN ELEKTRONISCHEN KARTE UND EINER SOLCHEN HALTERUNG, SPANNUNGSWANDLER, DER SIE UMFASST, UND ELEKTRISCHE MASCHINE FÜR KRAFTFAHRZEUG, DIE SIE UMFASST
MOUNTING OF AN ELECTRONIC CARD, ASSEMBLY OF AN ELECTRONIC CARD AND SUCH A MOUNTING, VOLTAGE CONVERTER COMPRISING SAME, AND ELECTRIC MACHINE FOR MOTOR VEHICLE COMPRISING SAME

(30) Priorité: 02.12.2015 FR 1561741
(43) Date de publication de la demande: 07.06.2017
(73) Titulaire: Valeo Systemes de Controle Moteur, 95800 Cergy Saint Christophe (FR)
(72) Inventeur: TRAMET, Guillaume, 78360 Montesson (FR); MAS, Arnaud, 95000 Cergy (FR); SACCO, Ernesto, 95000 Cergy (FR)
(74) Mandataire: Novembre, Christophe Adelphe

(56) Documents cités:
- EP-A2- 1 965 624
- WO-A1-2012/085397
- WO-A1-2015/033064
- JP-A- 2008 199 068
- JP-A- 2009 130 177
- JP-A- 2014 090 043
- US-A1- 2009 086 455

## Description

L'invention a pour objet un support configuré pour supporter une carte électronique, et un ensemble comprenant une carte électronique et un tel support. L'invention concerne également un convertisseur de tension comprenant un tel ensemble et une machine électrique pour véhicule automobile comprenant un tel convertisseur de tension.

Les cartes électroniques, également appelées circuits imprimés, sont des supports, en général présentés sous la forme d'une plaque, permettant de relier électriquement un ensemble de composants électroniques entre eux dans le but de réaliser un circuit électronique complexe.

Une carte électronique peut être connectée à un ou plusieurs types de composants, comme par exemple un connecteur électrique, une autre carte électronique, ou encore des composants électroniques de puissance. La connexion d'une carte électronique avec un composant est réalisée par l'insertion des contacts mâles du composant dans les contacts femelles correspondants de la carte électronique.

Cependant, une difficulté apparait lorsque l'on souhaite connecter une carte électronique à une pluralité de composants : les contacts mâles peuvent ne pas être correctement positionnés en face des contacts femelles correspondants. En effet, le jeu de montage associant les tolérances de positionnement des contacts mâles est supérieur au jeu laissé sur les contacts femelles pour réaliser la soudure.

Un mauvais positionnement des contacts mâles sur un composant peut entrainer un endommagement de ces contacts mâles lors de leur insertion dans les contacts femelles correspondants. Ce mauvais positionnement peut également provoquer une non connexion du composant à la carte électronique.

Les documents JP 2009 130177 A, JP 2008 199068 et WO 2015/033064 décrivent des supports de carte électronique.

Par ailleurs, dans le cas où la carte électronique et le support pour la carte électronique sont destinés à être intégrés dans un convertisseur de tension, lui-même destiné à être intégré dans une machine électrique tournante, un mauvais positionnement des contacts mâles sur un composant destiné à être connecté avec la carte électronique peut entraîner un dysfonctionnement du convertisseur de tension, et par conséquent de la machine tournante.

La présente invention vise à remédier à ces inconvénients en proposant un support de carte électronique permettant de connecter efficacement la carte électronique à au moins un composant.

A cet effet, l'invention a pour objet un support de carte électronique selon la revendication 1,

Avantageusement, grâce à tel support selon l'invention, les défauts de positionnement des contacts mâles sur les composants sont corrigés par les éléments de guidage qui permettent de recentrer les contacts mâles vers les contacts femelles.

Le support de carte électronique selon l'invention peut également comprendre une ou plusieurs des caractéristiques suivantes, considérées individuellement ou selon toutes les combinaisons possibles :
- les éléments de guidage comprennent des orifices de guidage ;
- les éléments de guidage comprennent un orifice de guidage par contact mâle, et/ou
- l'ouverture de l'extrémité des orifices située sur une face du support de la carte électronique est supérieure à l'ouverture de l'extrémité des orifices située sur la face opposée ;
- l'ouverture de l'extrémité des orifices située sur une face du support de la carte électronique est inférieure ou égale à la largeur du contact femelle de la carte électronique ;
- le support de carte électronique comprend des éléments de positionnement de la carte électronique sur le support de la carte électronique destinés à positionner la carte électronique sur le support de ladite carte électronique dans une position prédéterminée ;
- le support de carte électronique forme un boitier destiné à recevoir un gel d'étanchéité ;
- le support de la carte électronique est en matière plastique.

L'invention se rapporte également à un ensemble d'une carte électronique et d'un support de carte électronique tel que décrit précédemment et sur lequel est disposée la carte électronique, dans lequel les éléments de guidage du support de la carte électronique sont destinés à guider le au moins un contact mâle du au moins un composant vers le au moins un contact femelle correspondant de la carte électronique.

Selon un mode de réalisation de l'ensemble d'une carte électronique et du support de carte électronique, les éléments de guidage comprennent des orifices de guidage de sorte que l'ouverture de l'extrémité des orifices située du côté de la carte électronique est inférieure à l'ouverture de l'extrémité des orifices située du côté du au moins un composant.

L'invention a également pour objet un convertisseur de tension, notamment destiné à alimenter une machine électrique, comprenant au moins un ensemble d'une carte électronique et d'un support de la carte électronique tel que décrit précédemment.

De préférence, le ou chaque composant fait partie d'au moins un module électronique de puissance et la carte électronique est une carte de contrôle dudit module électronique.

Le convertisseur de tension peut également comprendre un boitier ayant un fond sur lequel le au moins un module électronique de puissance est monté, dans lequel le support de la carte électronique est positionné dans le boîtier de sorte à être en vis-à-vis dudit module électronique de puissance, le au moins un contact mâle dudit module électronique de puissance étant destiné à être guidé vers un contact femelle de la carte électronique par les éléments de guidage du support de ladite carte électronique.

Un autre objet de l'invention concerne une machine électrique pour véhicule automobile, comprenant au moins un convertisseur de tension tel que décrit précédemment et intégré au boitier de la machine. Par exemple, la machine électrique est un démarreur, un alterno-démarreur ou une autre machine embarquée dans le véhicule.

D'autres caractéristiques et avantages de la présente invention apparaitront à la lecture de la description et des figures suivantes :
- la Figure 1 est une vue générale d'un mode de réalisation d'un support de carte électronique selon l'invention,
- la Figure 2 représente une vue tridimensionnelle détaillée en coupe d'un support supportant une carte électronique connectée à un composant, et
- la Figure 3 est une vue éclatée d'un mode de réalisation d'un convertisseur de tension selon l'invention.

Il est à noter que ces dessins n'ont d'autre but que d'illustrer le texte de la description et ne constituent en aucune sorte une limitation de la portée de l'invention.

Sur les différentes figures, les éléments analogues sont désignés par des références identiques.

Dans la suite de la description, les termes « support de carte électronique » et « support de la carte électronique » sont utilisés indifféremment et doivent être considérés comme désignant le même dispositif.

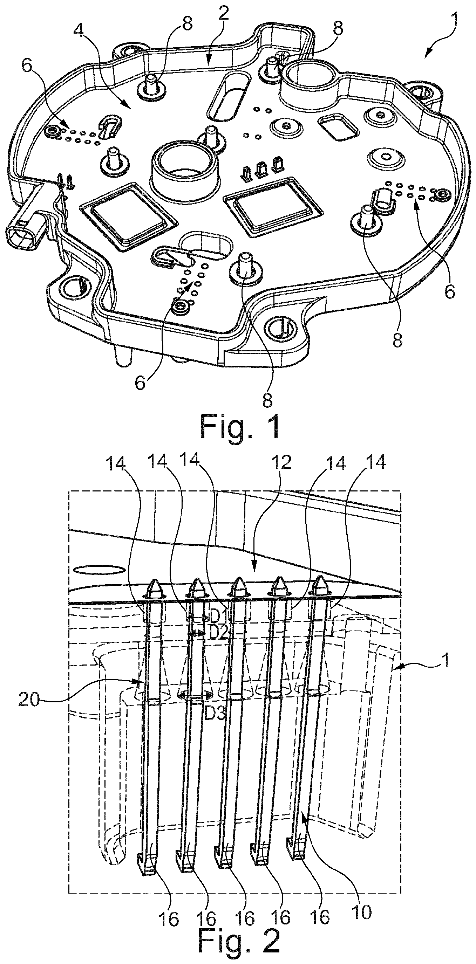

La Figure 1 est une vue générale d'un mode de réalisation d'un support 1 de carte électronique selon l'invention.

Le support 1 de carte électronique est configuré pour supporter une carte électronique destinée à être connectée à au moins un composant électronique. Le support 1 de carte électronique est agencé entre la carte électronique et le composant, comme cela est plus visible sur la Figure 2.

En outre, le support 1 de carte électronique forme un boitier comprenant une cavité ouverte 2, destinée à recevoir la carte électronique. A cet effet, le fond 4 de la cavité ouverte comprend avantageusement des éléments de guidage 6 qui seront décrits plus en détail dans la suite de la description. Par exemple, sur la Figure 1, le fond 4 de la cavité ouverte comprend trois groupes d'éléments de guidage 6. Le support 1 de carte électronique est de préférence en matière plastique.

Le support 1 de carte électronique est destiné à recevoir un matériau isolant permettant une isolation de la carte électronique à la poussière, aux liquides, aux gaz ou encore à l'humidité. Par exemple, le matériau isolant peut être une résine, telle que la résine époxy, ou un gel d'étanchéité, également appelé gel isolant, tel qu'un gel de silicone. La cavité ouverte 2 de réception de la carte électronique est de préférence remplie de gel isolant de sorte que la carte électronique soit noyée dans le gel isolant. Autrement dit, le gel d'étanchéité emplit l'espace intérieur libre du boitier autour des composants de la carte électronique. Le gel isolant permet ainsi l'étanchéité de la carte électronique, notamment l'étanchéité à la poussière et aux liquides. Le gel d'étanchéité permet ainsi de supprimer un risque de court-circuit possible au niveau de la carte électronique.

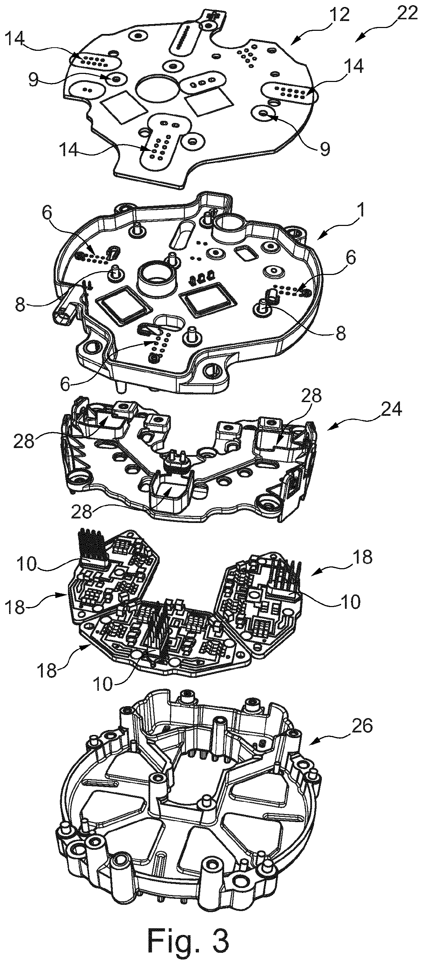

En outre, le support 1 de carte électronique comprend des éléments de positionnement 8 de la carte électronique destinés à la positionner sur le support 1 dans une position prédéterminée. Autrement dit, les éléments de positionnement 8 disposés sur le support 1 de la carte électronique sont destinés à coopérer avec des éléments de positionnement complémentaires 9 de la carte électronique. Par exemple, sur la Figure 1, six éléments de positionnement 8 sont représentés, comprenant chacun un ergot faisant saillie depuis le fond 4 de la cavité ouverte, de façon perpendiculaire au fond 4. Les éléments de positionnement 8 peuvent être de forme cylindrique comme représenté sur la Figure 1. Les six éléments de positionnement complémentaires 9 de la carte électronique sont des orifices de positionnement, visibles sur la Figure 3, présentant de préférence une section de forme et de dimensions complémentaires à la forme et aux dimensions des éléments de positionnement 8. Par exemple, comme illustré sur la Figure 3, les éléments de positionnement complémentaires 9 présentent une section circulaire.

Les éléments de guidage vont maintenant être détaillés en regard de la Figure 2 qui illustre une vue tridimensionnelle partiellement en coupe et agrandie de la carte électronique 12, du support 1 de celle-ci et d'un composant électronique 10, qui peut, par exemple, faire partie d'un module électronique de puissance.

La carte électronique 12 comprend au moins un contact femelle 14. De préférence, la carte électronique 12 comprend une pluralité de contacts métalliques femelles 14. Par exemple, sur la Figure 2, cinq contacts femelles 14 sont représentés. Avantageusement, les contacts femelles 14 sont des orifices, de préférence de forme cylindrique, dans lesquels des contacts mâles sont destinés à être insérés. Les contacts femelles 14 peuvent présenter toute forme de section, et notamment une section circulaire de diamètre noté D1, comme représenté sur la Figure 2.

Le composant électronique 10 comprend au moins un contact mâle 16. De préférence, le composant 10 comprend autant de contacts mâles 16 que de contacts femelles 14 sur la carte électronique 12. Par exemple, sur la Figure 2, cinq contacts mâles 16 sont représentés. De manière avantageuse, les contacts mâles sont des électrodes et sont destinés à être insérés dans les contacts femelles 14 correspondants de la carte électronique 12. Les contacts mâles 16 peuvent être de forme cylindrique à section quelconque et par exemple à section rectangulaire, comme illustré sur la Figure 2, où une diagonale de la section est inférieure à D1. Les contacts mâles 16 du composant 10 sont destinés à être guidés vers les contacts femelles 14 correspondants de la carte électronique 12 par les éléments de guidage 6 du support 1 de ladite carte électronique.

A cet effet, les éléments de guidage 6 du support 1 de carte électronique comprennent des orifices de guidage 20. Avantageusement, les éléments de guidage 6 comprennent un orifice de guidage 20 par contact mâle 16. Les orifices de guidage 20 permettent de recentrer les contacts mâles 16 et d'éviter que ces derniers ne dévient hors des contacts femelles 14 lors de l'insertion des contacts mâles 16 dans les contacts femelles 14 correspondants. Grâce à ce dispositif, les contacts mâles 16 peuvent être correctement insérés dans les contacts femelles 14 correspondants de la carte électronique 12, puis soudés sur ladite carte électronique 12.

La section d'entrée des orifices de guidage 20 est définie comme étant la section située du côté des composants 10, plus précisément comme étant la section par laquelle les contacts mâles 16 des composants 10 sont insérés dans les orifices 20 des éléments de guidage 6 du support 1 de carte électronique. De façon analogue, la section de sortie des orifices de guidage 20 est définie comme étant la section située du côté de la carte électronique 12.

Afin de permettre un meilleur recentrage des contacts mâles 16, la section d'entrée des orifices 20 des éléments de guidage 6 du support 1 de carte électronique est de préférence plus grande que la section de sortie des orifices de guidage 20. On appelle section d'entrée, la section des orifices des éléments de guidage 6 en regard des composants et section de sortie, la section des orifices en regard de la carte électronique. Autrement dit, l'ouverture de l'extrémité des orifices située sur une face du support de la carte électronique 12 est supérieure à l'ouverture de l'extrémité des orifices située sur la face opposée. L'ouverture peut être calculée de manière à tenir compte des tolérances de placement de tous les contacts mâles 16 devant être soudés sur la carte électronique 12.

Afin de permettre un meilleur recentrage des contacts mâles 16, la section de sortie des orifices de guidage 20 est de préférence plus petite que la largeur des contacts femelles 14, la largeur des contacts femelles 14 correspondant à la section des contacts femelles 14. Autrement dit, l'ouverture de l'extrémité des orifices située sur une face du support de la carte électronique 12 est inférieure ou égale à la largeur du contact femelle 14 de la carte électronique 12.

Les orifices de guidage 20 peuvent présenter toute forme de section, et notamment une section circulaire, comme illustré sur la Figure 2, où la section d'entrée des orifices de guidage correspond au disque de diamètre noté D3 et la section de sortie des orifices de guidage correspond au disque de diamètre noté D2. Les orifices de guidage 20 peuvent également être de forme tronconique, ou comporter une portion tronconique dont le diamètre de chaque extrémité a pour valeur D2 et D3, suivie d'une portion cylindrique de diamètre D2, comme représenté sur la Figure 2.

Selon un mode de réalisation, la carte électronique 12 est tout d'abord fixée sur le support 1 de carte électronique grâce aux éléments de positionnement 8, 9. Les orifices 20 des éléments de guidage 10 du support 1 de carte électronique sont ainsi disposés en vis-à-vis des contacts femelles 14 correspondants de la carte électronique 12. Les contacts mâles 16 des composants 10 sont par la suite insérés chacun dans un orifice 20 des éléments de guidage jusqu'au contact femelle 14 correspondant auquel ils sont soudés sur l'ensemble de la carte électronique 12 et du support 1 de ladite carte électronique.

Selon un autre mode de réalisation, les contacts mâles 16 des composants 10 sont tout d'abord insérés dans les orifices 20 des éléments de guidage 10 du support 1 de la carte électronique. Ensuite, la carte électronique 12 est reçue par le support 1 de carte électronique grâce aux éléments de positionnement 8, 9 garantissant ainsi que les contacts mâles 16 des composants 10 sont insérés dans les contacts femelles 14 correspondants de la carte électronique 12 avant d'y être soudés.

L'invention a également pour objet une machine électrique tournante comprenant un dispositif électronique, tel qu'un convertisseur de tension 22 comprenant un ensemble d'une carte électronique 12 et de son support 1, un connecteur électrique 24, et un ensemble d'un module électronique de puissance 18 et de son support 26.

La Figure 3 est une vue éclatée d'un mode de réalisation d'un convertisseur de tension 22 selon l'invention. Le convertisseur de tension 22 comprend une carte électronique 12, un support 1 de carte électronique, un connecteur électrique 24, des modules électroniques de puissance 18, dans cet exemple au nombre de trois, et un support 26 de module électronique de puissance.

Le convertisseur de tension 22 est notamment destiné à alimenter la machine électrique tournante. De préférence, le convertisseur de tension 22 est intégré au boitier de la machine tournante. Avantageusement, le convertisseur de tension 22 est un convertisseur alternatif-continu.

La carte électronique 12, comme décrite de façon plus détaillée ci-avant, comprend des contacts femelles 14 destinés à coopérer avec les contacts mâles 16 correspondants des composants 10. Par exemple, chaque composant 10 fait partie d'au moins un module électronique de puissance 18. Dans ce cas, la carte électronique 12 est notamment une carte de contrôle des modules de puissance 18.

Comme indiqué précédemment, le support 1 de la carte électronique est destiné à recevoir la carte électronique 12. Le support 1 de carte électronique est, de préférence, positionné dans le support 26 de modules électroniques de puissance de sorte à être en vis-à-vis des modules électroniques de puissance 18. De préférence, le support 1 de carte électronique est fixé au support 26 de module de puissance. En outre, le support de carte électronique comprend des éléments de guidage 6 et des éléments de positionnement 8 tels que décrits précédemment.

Chaque module électronique de puissance 18 est destiné à être connecté à la carte électronique 12 et à des éléments électriques de la machine électrique. Les éléments électriques de la machine électrique tournante sont, par exemple, des phases ϕ, une source d'énergie électrique continue positive B⁺, une source d'énergie électrique continue négative B⁻ ou la masse. Il y a de préférence un module de puissance par phase. Les modules électroniques de puissance 18 sont destinés à être supportés par le support 26 de module électronique.

Le connecteur électrique 24 est configuré pour interconnecter les modules électroniques de puissance 18 et pour connecter électriquement chaque module électronique de puissance 18 aux éléments électriques de la machine électrique tournante. Sur la Figure 3, le connecteur électrique est agencé entre chacun des modules électroniques de puissance 18 et le support 1 de carte électronique. Le connecteur électrique 24 comprend des orifices 28 agencés pour autoriser l'accès des contacts mâles 16 des composants 10 aux contacts femelles 14 en vue de leur connexion à la carte électronique 12.

Le support 26 de module électronique de puissance est avantageusement un boitier ayant un fond sur lequel le ou les modules de puissance 18 sont montés. Le boitier comprend de façon avantageuse des cavités dans lesquelles les modules de puissance 18 sont montés. De façon avantageuse, le support 26 de module puissance est un dissipateur de chaleur, aussi nommé dissipateur thermique. Les modules de puissance 18 sont fixés au dissipateur thermique afin de permettre le transfert thermique entre les modules de puissance 18 et un circuit de refroidissement (non représenté), afin de dissiper la chaleur générée par les modules de puissance 18.

Le support de carte électronique a été décrit dans le cadre d'un convertisseur de tension notamment destiné à alimenter une machine électrique tournante. D'autres applications du support de carte électronique conforme à l'invention sont également possibles sans sortir du cadre de l'invention.

## Revendications

1. Support d'une carte électronique (1) configuré pour supporter une carte électronique (12) destinée à être connectée à au moins un composant (10), le au moins un composant (10) comprenant au moins un contact mâle (16) destiné à être inséré dans un contact femelle (14) correspondant de la carte électronique (12), le support (1) de la carte électronique étant destiné à être agencé entre la carte électronique (12) et le au moins un composant (10) et comprenant des éléments de guidage (6) du au moins un contact mâle (16) vers le contact femelle (14) correspondant, ledit support étant **caractérisé en ce que** ledit support forme un boitier destiné à recevoir un gel d'étanchéité, ledit boitier comprend une cavité ouverte (2) destinée à recevoir ladite carte électronique, un fond (4) de ladite cavité comprend lesdits éléments de guidage (6), la cavité ouverte (2) est remplie dudit gel d'étanchéité de sorte que ladite carte électronique soit noyée dans ledit gel, ledit support comprend des éléments de positionnement (8) de la carte électronique (12) sur ledit support (1) destinés à positionner la carte électronique (12) sur ledit support (1) dans une position prédéterminée.

2. Support d'une carte électronique selon la revendication 1, dans lequel les éléments de guidage (6) comprennent des orifices de guidage (20).

3. Support d'une carte électronique selon la revendication 2, dans lequel les éléments de guidage (6) comprennent un orifice de guidage (20) par contact mâle (16).

4. Support d'une carte électronique selon la revendication 2 ou 3, dans lequel l'ouverture (D3) de l'extrémité des orifices située sur une face du support (1) de la carte électronique est supérieure à l'ouverture (D2) de l'extrémité des orifices située sur la face opposée.

5. Support d'une carte électronique selon l'une quelconque des revendications 2 à 4, dans lequel l'ouverture (D2) de l'extrémité des orifices située sur une face du support (1) de la carte électronique est inférieure ou égale à la largeur (D1) du contact femelle (14) de la carte électronique (12).

6. Support d'une carte électronique selon l'une quelconque des revendications 1 à 5, dans lequel le support (1) de la carte électronique est en matière plastique.

7. Ensemble d'une carte électronique (12) et d'un support (1) d'une carte électronique selon l'une quelconque des revendications 1 à 6 sur lequel est disposée la carte électronique (12), dans lequel les éléments de guidage (6) du support (1) de la carte électronique sont destinés à guider le au moins un contact mâle (16) du au moins un composant (10) vers le au moins un contact femelle (14) correspondant de la carte électronique (12).

8. Ensemble d'une carte électronique et d'un support (1) d'une carte électronique selon la revendication 7, dans lequel les éléments de guidage (6) comprennent des orifices de guidage (20) de sorte que l'ouverture (D2) de l'extrémité des orifices située du côté de la carte électronique est inférieure à l'ouverture (D3) de l'extrémité des orifices située du côté du au moins un composant (10).

9. Convertisseur de tension (22), notamment destiné à alimenter une machine électrique, **caractérisé en ce qu'**il comprend au moins un ensemble d'une carte électronique (12) et d'un support (1) de la carte électronique selon la revendication 7 ou 8.

10. Convertisseur de tension selon la revendication 9, **caractérisé en ce que** le ou chaque composant (10) fait partie d'au moins un module électronique de puissance (18) et **en ce que** la carte électronique (12) est une carte de contrôle dudit module électronique (18).

11. Convertisseur de tension selon la revendication précédente, **caractérisé en ce qu'**il comprend un boitier ayant un fond sur lequel le au moins un module électronique de puissance (18) est monté, dans lequel le support (1) de la carte électronique est positionné dans le boîtier de sorte à être en vis-à-vis dudit module électronique de puissance (18), le au moins un contact mâle (16) dudit module électronique de puissance (18) étant destiné à être guidé vers un contact femelle (14) de la carte électronique (12) par les éléments de guidage (6) du support (1) de ladite carte électronique.

12. Machine électrique pour véhicule automobile, **caractérisée en ce qu'**elle comprend au moins un convertisseur de tension (22) selon l'une des revendications 9 à 11 intégré au boitier de la machine.

## Patentansprüche

1. Träger (1) einer Elektronikkarte, der konfiguriert ist, eine Elektronikkarte (12) zu tragen, die dazu bestimmt ist, mit mindestens einem Bauteil (10) verbunden zu werden, wobei das mindestens eine Bauteil (10) mindestens einen Einsteckkontakt (16) enthält, der dazu bestimmt ist, in einen entsprechenden Aufnahmekontakt (14) der Elektronikkarte (12) eingeführt zu werden, wobei der Träger (1) der Elektronikkarte dazu bestimmt ist, zwischen der Elektronikkarte (12) und dem mindestens einen Bauteil (10) angeordnet zu sein und Führungselemente (6) des mindestens einen Einsteckkontakts (16) zum entsprechenden Aufnahmekontakt (14) enthält, wobei der Träger **dadurch gekennzeichnet ist, dass** der Träger ein Gehäuse bildet, das dazu bestimmt ist, ein Dichtungsgel aufzunehmen, wobei das Gehäuse einen offenen Hohlraum (2) enthält, der dazu bestimmt ist, die Elektronikkarte aufzunehmen, wobei ein Boden (4) des Hohlraums die Führungselemente (6) enthält, wobei der offene Hohlraum (2) mit dem Dichtungsgel gefüllt ist, so dass die Elektronikkarte in das Gel eingebettet wird, wobei der Träger Positionierelemente (8) der Elektronikkarte (12) auf dem Träger (1) enthält, die dazu bestimmt sind, die Elektronikkarte (12) auf dem Träger (1) in einer vorbestimmten Stellung zu positionieren.

2. Träger einer Elektronikkarte nach Anspruch 1, wobei die Führungselemente (6) Führungsöffnungen (20) enthalten.

3. Träger einer Elektronikkarte nach Anspruch 2, wobei die Führungselemente (6) eine Führungsöffnung (20) pro Einsteckkontakt (16) enthalten.

4. Träger einer Elektronikkarte nach Anspruch 2 oder 3, wobei die Öffnungsfläche (D3) des Endes der Öffnungen, das sich auf einer Seite des Trägers (1) der Elektronikkarte befindet, größer ist als die Öffnungsfläche (D2) des Endes der Öffnungen, das sich auf der gegenüberliegenden Seite befindet.

5. Träger einer Elektronikkarte nach einem der Ansprüche 2 bis 4, wobei die Öffnungsfläche (D2) des Endes der Öffnungen, das sich auf einer Seite des Trägers (1) der Elektronikkarte befindet, kleiner als die oder gleich der Breite (D1) des Aufnahmekontakts (14) der Elektronikkarte (12) ist.

6. Träger einer Elektronikkarte nach einem der Ansprüche 1 bis 5, wobei der Träger (1) der Elektronikkarte aus Kunststoff ist.

7. Einheit aus einer Elektronikkarte (12) und einem Träger (1) einer Elektronikkarte nach einem der Ansprüche 1 bis 6, auf dem die Elektronikkarte (12) angeordnet ist, wobei die Führungselemente (6) des Trägers (1) der Elektronikkarte dazu bestimmt sind, den mindestens einen Einsteckkontakt (16) des mindestens einen Bauteils (10) zum mindestens einen entsprechenden Aufnahmekontakt (14) der Elektronikkarte (12) zu führen.

8. Einheit aus einer Elektronikkarte und einem Träger (1) einer Elektronikkarte nach Anspruch 7, wobei die Führungselemente (6) derartige Führungsöffnungen (20) enthalten, dass die Öffnungsfläche (D2) des Endes der Öffnungen, das sich auf der Seite der Elektronikkarte befindet, kleiner ist als die Öffnungsfläche (D3) des Endes der Öffnungen, das sich auf der Seite des mindestens einen Bauteils (10) befindet.

9. Spannungswandler (22), insbesondere dazu bestimmt, eine elektrische Maschine zu versorgen, **dadurch gekennzeichnet, dass** er mindestens eine Einheit aus einer Elektronikkarte (12) und einem Träger (1) der Elektronikkarte nach Anspruch 7 oder 8 enthält.

10. Spannungswandler nach Anspruch 9, **dadurch gekennzeichnet, dass** das oder jedes Bauteil (10) Teil mindestens eines elektronischen Leistungsmoduls (18) ist, und dass die Elektronikkarte (12) eine Kontrollkarte des elektronischen Moduls (18) ist.

11. Spannungswandler nach dem vorhergehenden Anspruch, **dadurch gekennzeichnet, dass** er ein Gehäuse enthält, das einen Boden hat, auf den das mindestens eine elektronische Leistungsmodul (18) montiert ist, wobei der Träger (1) der Elektronikkarte so im Gehäuse positioniert ist, dass er dem elektronischen Leistungsmodul (18) gegenüberliegt, wobei der mindestens eine Einsteckkontakt (16) des elektronischen Leistungsmoduls (18) dazu bestimmt ist, zu einem Aufnahmekontakt (14) der Elektronikkarte (12) durch die Führungselemente (6) des Trägers (1) der Elektronikkarte geführt zu werden.

12. Elektrische Maschine für ein Kraftfahrzeug, **dadurch gekennzeichnet, dass** sie mindestens einen Spannungswandler (22) nach einem der Ansprüche 9 bis 11 enthält, der in das Gehäuse der Maschine eingebaut ist.

## Claims

1. Support for an electronic circuit board (1) configured to support an electronic circuit board (12) intended to be connected to at least one component (10), the at least one component (10) comprising at least one male contact (16) intended to be inserted into a corresponding female contact (14) of the electronic circuit board (12), the support (1) for the electronic circuit board being intended to be arranged between the electronic circuit board (12) and the at least one component (10) and comprising guiding elements (6) for guiding the at least one male contact (16) to the corresponding female contact (14), said support being **characterized in that** said support forms a housing intended to receive a sealing gel, said housing comprising an open cavity (2) intended to receive said electronic circuit board, a bottom (4) of said cavity comprises said guiding elements (6), the open cavity (2) is filled with said sealing gel so that said electronic circuit board is embedded in said gel, said support comprises positioning elements (8) for positioning the electronic circuit board (12) on said support (1) that are intended to position the electronic circuit board (12) on said support (1) in a predetermined position.

2. Support for an electronic circuit board according to Claim 1, wherein the guiding elements (6) comprise guiding orifices (20).

3. Support for an electronic circuit board according to Claim 2, wherein the guiding elements (6) comprise one guiding orifice (20) for each male contact (16).

4. Support for an electronic circuit board according to Claim 2 or 3, wherein the opening (D3) of the end of the orifices situated on a face of the support (1) for the electronic circuit board is greater than the opening (D2) of the end of the orifices situated on the opposite face.

5. Support for an electronic circuit board according to any one of Claims 2 to 4, wherein the opening (D2) of the end of the orifices situated on a face of the support (1) for the electronic circuit board is less than or equal to the width (D1) of the female contact (14) of the electronic circuit board (12).

6. Support for an electronic circuit board according to any one of Claims 1 to 5, wherein the support (1) for the electronic circuit board is made of plastic material.

7. Assembly of an electronic circuit board (12) and a support (1) for an electronic circuit board according to any one of Claims 1 to 6 on which the electronic circuit board (12) is disposed, wherein the guiding elements (6) of the support (1) for the electronic circuit board are intended to guide the at least one male contact (16) of the at least one component (10) to the at least one corresponding female contact (14) of the electronic circuit board (12).

8. Assembly of an electronic circuit board and a support (1) for an electronic circuit board according to Claim 7, wherein the guiding elements (6) comprise guiding orifices (20) such that the opening (D2) of the end of the orifices situated on the side of the electronic circuit board is smaller than the opening (D3) of the end of the orifices situated on the side of the at least one component (10).

9. Voltage converter (22), notably intended to power an electrical machine, **characterized in that** it comprises at least one assembly of an electronic circuit board (12) and a support (1) for the electronic circuit board according to Claim 7 or 8.

10. Voltage converter according to Claim 9, **characterized in that** the or each component (10) forms part of at least one power electronic module (18) and **in that** the electronic circuit board (12) is a control board of said electronic module (18).

11. Voltage converter according to the preceding claim, **characterized in that** it comprises a housing having a bottom on which the at least one power electronic module (18) is mounted, wherein the support (1) for the electronic circuit board is positioned in the housing so as to be facing said power electronic module (18), the at least one male contact (16) of said power electronic module (18) being intended to be guided to a female contact (14) of the electronic circuit board (12) by the guiding elements (6) of the support (1) for said electronic circuit board.

12. Electrical machine for a motor vehicle, **characterised in that** it comprises at least one voltage converter (22) according to one of Claims 9 to 11 incorporated in the housing of the machine.
